# EUROPÄISCHE PATENTANMELDUNG

(11) **EP 0 947 845 A2**
(43) Veröffentlichungstag der Anmeldung: **06.10.1999**
(21) Anmeldenummer: 99102975.2
(22) Anmeldetag: 15.02.1999
(51) Int. Cl.: G01R 31/28

(54) **Vorrichtung zum automatischen Testen von Komponenten**

(30) Priorität: 31.03.1998 DE 19814312
(71) Anmelder: Deutsche Telekom AG, 53113 Bonn (DE)
(72) Erfinder: Kölmel, Klaus, 76470 Ötigheim (DE)

(57) **Zusammenfassung**

Es wird eine Vorrichtung zum Testen von Baugruppen bzw. Bauteilen, insbesondere elektrischen oder elektronischen Baugruppen in Form eines Testautomaten 1 mit Testkopf- bzw. -adapter angegeben. Die Baugruppen, Bauteile bzw. Komponenten werden auf dem Testkopf bzw. -adapter des Testautomaten 1 während der Testphase mit Unterdruck korrekt und sicher in der Testposition gehalten. Der Unterdruck wird durch eine Vakuumpumpe (2) erzeugt, die über eine Verbindung (3) mit einem Magnetventil (4) verbunden ist, das seinerseits über eine Verbindung (5) mit dem Testkopf bzw. -adapter des Testautomaten (1) in Verbindung steht. Das Magnetventil (4) mit Vakuumanschluß wird über eine Leitung (11) vom Testautomaten gesteuert. Durch dieses Magnetventil (4) mit Vakuumanschluß wird am Ende des Testes der Unterdruck abgeschaltet. Die getesteten Baugruppen konnten bisher erst nach vollständigem Druckausgleich vom Testkopf bzw. -adapter gelöst werden. Durch den Einbau eines weiteren Magnetventils (8) mit Druckluftanschluß sowie einer über die Steuerleitung (11) gesteuerten Ansteuerelektronik (10) und eine Leitung (12) wird die Zeit bis zum Lösen eines Bauteils auf 1 Sekunde oder kürzer verringert. Das Magnetventil (8) mit Druckluftanschluß ist über eine Verbindung 7 mit einer Druckluftquelle (6) verbunden und über eine Verbindung (9) mittelbar oder unmittelbar mit der Verbindung (5) zwischen dem Testkopf bzw. -adapter des Testautomaten (1) und dem Magnetventil (4) mit Vakuumanschluß.

## Beschreibung

Die Erfindung betrifft eine Vorrichtung zum automatischen Testen von Komponenten, insbesondere Schaltungskomponenten, nach dem Oberbegriff des Patentanspruchs 1.

Testautomaten zum Testen elektronischer Komponeten bzw. Komponentengruppen, sind grundsätzlich bekannt. Derartige Testautomaten sind mit einem Testkopf ausgerüstet, auf dem das zu testende Bauteil oder die zu testende Baugruppe bzw. das Modul zum Zwecke des Testens aufgesetzt wird. Das zu testende Teil wird dabei durch Unterdruck auf dem Testkopf während der Testphase exakt und sicher in der Testposition gehalten, um Fehlmessungen bzw. Fehltesten und Fehler zu vermeiden. Ein solches Gerät ist zum Beispiel das Testautomaten-System HP 3070 der Firma Hewlett Packard Company, USA. Bei diesem Gerät ist der Testkopf des Testautomaten mit einer Vakuumpumpe verbunden. Vom Testautomten gesteuert liegt zwischen dem Testkopf und der Vakuumpumpe ein Magnetventil. Im Einsatz beträgt die durchschnittliche Testzeit der Baugruppen ca. 5 Minuten. Wie bereits erwähnt, wird die Baugruppe während des Testes mit Unterdruck auf dem Testkopf bzw. auf dem Testsystem festgehalten. Am Ende des Testes wird der Unterdruck durch das genannte Magnetventil abgeschaltet, um die getestete Baugruppe dem Testkopf des Testautomaten entnehmen zu können. Die bekannte Vorrichtung hat jedoch den Nachteil, daß die Baugruppen erst nach vollständigem Druckausgleich von dem jeweiligen Testkopf bzw. Testadapter gelöst werden können. Die Zeitdauer dafür beträgt zwischen 5 und 20 Sekunden, wodurch im täglichen Betrieb relativ viel Zeit ungenutzt bleibt.

Der Erfindung liegt deshalb die Aufgabe zugrunde, eine Vorrichtung zum Testen von Baugruppen, insbesondere elektrischen oder elektronischen Baugruppen bzw. Modulen zu schaffen, die ein schnelleres Lösen der getesteten Baugruppe bzw. des Moduls am Ende des Testvorgangs ermöglicht und damit die Gesamttestzeit verringert.

Die erfindungsgemäße Lösung ist im Kennzeichen des Patentanspruchs 1 charakterisiert.

Weitere Lösungen bzw. Ausgestaltungen sind in den Kennzeichen der Patentansprüche 2 bis 5 angegeben.

Dadurch, daß in die Verbindung zwischen dem der Vakuumpumpe zugeordneten Magnetventil und dem Testkopf bzw. -system ein weiteres Magnetventil mit Druckluftanschluß und entsprechender Ansteuerelektronik zur gesteuerten Zuführung von Druckluft am Ende eines Testvorgangs angeordnet ist, entfällt praktisch der sonst erforderliche Druckausgleich zum Entfernen der getesteten Baugruppen. Damit wird ein wesentlicher Zeitgewinn pro getestetem Bauteil bzw. pro getesteter Baugruppe oder dergleichen erzielt. In der Praxis hat sich durch den Einbau eines Magnetventils mit Druckluftanschluß und entsprechender Ansteuerelektronik die Zeit, die bis zum Lösen der Baugruppe erforderlich ist, auf ca. 1 Sekunde verkürzt.

Weitere Vorteile, Merkmale und Anwendungsmöglichkeiten der vorliegenden Erfindung, insbesondere der Anordnung des Magnetventils mit Druckluftanschluß, ergeben sich aus der nachfolgenden Beschreibung in Verbindung mit dem in der Zeichnung dargestellten Ausführungsbeispiel.

Die Erfindung wird im folgenden anhand von Ausführungsbeispielen, insbesondere eines in der Zeichnung dargestellten Ausführungsbeispiels, näher beschrieben. In der Beschreibung, in den Patentansprüchen, der Zusammenfassung und in der Zeichnung werden die in der hinten angeführten Liste der Bezugszeichen verwendeten Begriffe und zugeordneten Bezugszeichen verwendet.

In der Zeichnung bedeuten:

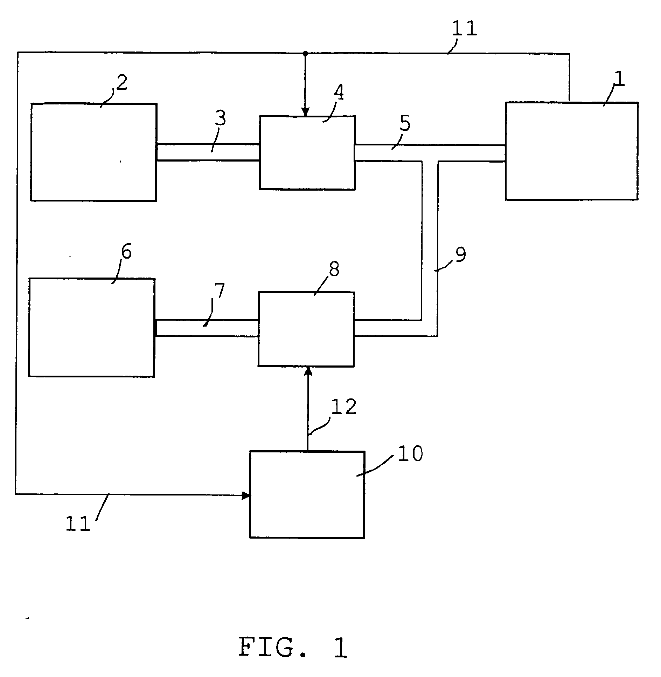

- Fig. 1: eine grundsätzliche Anordnung eines Magnetventils mit Druckluftanschluß zur Verbesserung eines Testautomaten.

In Fig. 1 ist ein Testautomat 1 gezeigt, der mit einem bekannten Testkopf bzw. -adapter oder Testsystem ausgerüstet ist. Darauf wird das zu prüfende Bauteil bzw. die zu prüfende Baugruppe aufgesetzt und bekannterweise durch Unterdruck gehalten. Der Unterdruck wird durch eine Vakuumpumpe 2 erzeugt, die über eine Verbindung 3 mit einem Magnetventil 4 verbunden ist, das seinerseits über eine Verbindung 5 mit dem Testautomaten 1, insbesondere dem Testkopf bzw. -adapter verbunden ist. Das Magnetventil 4 wird vom Testautomaten gesteuert und ist deshalb über eine Leitung 11 mit diesem verbunden. Durch das Magnetventil 4 gelangt entweder der Unterdruck am Testkopf bzw. -adapter zur Wirkung und hält das zu testende Bauteil oder es verhindert im gesperrten Zustand das Wirken des von der Vakuumpumpe 2 aufgebauten Vakuums. Im letzteren Falle wird dann nach einer bestimmten Zeit der Unterdruck am Testkopf bzw. -system oder -adapter abgebaut und erst danach läßt sich das getestete Bauteil entfernen. Um den daraus resultierenden Zeitverlust wesentlich zu verringern, ist in der Vorrichtung nach Fig. 1 ein weiteres Magnetventil 8 mit Druckluftanschluß in das Leitungssystem des Testautomaten 1 eingefügt worden. Das Magnetventil 8 ist über eine Verbindung 7 mit einer Druckluftquelle 6 verbunden und mit einer Verbindung 9 mit der bereits vorhandenen Verbindung 5. Die Verbindungen 3, 5, 7 und 9 sind normalerweise als Druckleitungen oder als Druckschläuche ausgeführt, wobei die Verbindung zwischen den beiden genannten Verbindungen 5 und 9 mittelbar bzw. unmittelbar vor bzw. am Testkopf bzw. -adapter direkt miteinander verbunden sind. Das Magnetventil 8 mit Druckluftanschluß wird durch eine Ansteuerelektronik 10 über eine Leitung 12 gesteuert, wobei die Auslöseimpulse vom Testautomaten 1 über die Leitung 11 auf die Ansteuerelektronik gegeben werden. Dabei ist es sehr wichtig, daß das Magnetventil 8 mit Druckluftanschluß unmittelbar mit dem Abschalten des Vakuums betätigt wird, wodurch die Druckluft über die Verbindungen 7, 9 und 5 in kürzester Zeit zum Testkopf bzw. -adapter gelangt. In der Praxis geschieht dies zwischen 0,5 und 1 Sekunde. Damit ist durch den Einbau des Magnetventils 8 mit Druckluftanschluß die Zeit zum Lösen eines Bauteils vom Testkopf bzw. -adapter auf eine Sekunde oder weniger verkürzt.

### Liste der Bezugszeichen

- 1: Testautomat mit Testkopf bzw. -adapter
- 2: Vakuumpumpe
- 3,5,7,9: Verbindungen
- 4: Magnetventil mit Vakuumanschluß
- 6: Druckluft bzw. Druckluftquelle
- 8: Magnetventil mit Druckluftanschluß
- 10: Ansteuerelektronik
- 11,12: Leitungen

## Patentansprüche

1. Vorrichtung zum automatischen Testen von Baugruppen oder Bauteilen, insbesondere elektrischen oder elektronischen Baugruppen bzw. Komponenten, wobei die zu testenden Baugruppen bzw. Bauteile durch Unterdruck auf einen Testkopf bzw. -adapter während der Testphase sicher und korrekt gehalten werden, indem ein durch eine Vakuumpumpe erzeugter Unterdruck am Testkopf bzw. -adapter erzeugt wird, der durch ein zwischen der Vakuumpumpe und dem Testkopf bzw. -adapter angeordnetes Magnetventil auf bzw. abgebaut wird, indem das Magnetventil mit Vakuumanschluß über eine Steuerleitung vom Testautomaten entsprechende Steuersignale erhält, dadurch gekennzeichnet,
daß ein Magnetventil (8) mit Druckluftanschluß in die Verbindung (5) des erstgenannten Magnetventils (4) und des Testautomaten (1) mit Testkopf bzw. -adapter über eine Verbindung (9) eingefügt ist,
daß das Magnetventil (8) mit Druckluftanschluß über eine Ansteuerelektronik (10) und eine Leitung (12) Signale zum Ein- oder Abschalten der Druckluft erhält und
daß die Ansteuerelektronik (10) für das Magnetventil (8) mit Druckluftanschluß über die Leitung (11) mit dem Testautomaten (1) zur Steuerung verbunden ist.

2. Vorrichtung nach Patentanspruch 1, dadurch gekennzeichnet,
daß das Magnetventil (8) mit Druckluftanschluß unmittelbar nach Schließen des Magnetventils (4) mit Vakuumanschluß durch Steuersignale auf einer gemeinsamen Steuerleitung (11) geöffnet wird.

3. Vorrichtung nach einem der Patentansprüche 1 oder 2, dadurch gekennzeichnet,
daß bei einer Anordnung mehrerer Magnetventile (4) mit Vakuumanschluß eine entsprechende Anzahl Magnetventile (8) mit Druckluftanschluß angeordnet ist.

4. Vorrichtung nach einem der Patentansprüche 1 bis 3, dadurch gekennzeichnet,
daß bei einer Anordnung von mehreren Magnetventilen (4) mit Vakuumanschluß nur ein gemeinsames Magnetventil (8) mit Druckluftanschluß angeordnet ist und direkt oder indirekt über einen entsprechenden Adapter mit den Verbindungen (5) zum gesteuerten Zu- oder Abschalten von Druckluft verbunden ist.

5. Vorrichtung nach einem der Patentansprüche 1 bis 4, dadurch gekennzeichnet,
daß die Verbindungen (3, 5, 7 und 9) als Druckleitungssystem aus Druckschläuchen und/oder Druckleitungen ausgeführt sind.
